# EUROPEAN PATENT SPECIFICATION

(11) **EP 1 278 406 B1**
(45) Date of publication and mention of the grant of the patent: **02.02.2005**
(21) Application number: 01830478.2
(22) Date of filing: 19.07.2001
(51) Int. Cl.: H05K 3/46

(54) **Apparatus for making multi-layered printed circuits**
Vorrichtung zum Herstellen von mehrlagigen Schaltungsplatten
Appareil pour la fabrication de circuits à multicouches

(43) Date of publication of application: 22.01.2003
(73) Proprietor: TAPEMATIC S.p.A., 20060 Ornago (MI) (IT)
(72) Inventor: Perego, Luciano, 20050 Mezzago (MI) (IT)
(74) Representative: Tansini, Elio Fabrizio

(56) References cited:
- DE-A- 19 628 163
- DE-U- 9 317 228

## Description

The present invention relates to an apparatus for making cards for multi-layered printed circuits, of the type comprising the features set forth in the preamble of claim 1.

The present invention addresses to the electronic sector and in particular to the production of printed circuits normally used in computers, telephones or electronic apparatus of various kinds. More specifically, the apparatus in accordance with the invention lends itself to be used in the step of assembling the different layers forming a multi-layered card.

It is known that two or more types of conductive layers, usually referred to as "inner layers", on which the respective conductive paths are disposed, must be superposed and joined to form a finished card. An insulating film, called "pre-peg" and also performing the function of bonding agent or glue is interposed between a conductive layer and the next one.

For the purpose, automatic apparatus are used that are adapted to individually pick up the conductive layers and insulating films and lay them down in an alternate sequence in an assembling station for alignment and subsequent junction of same.

The conductive and insulating layers are piled up in adjacent containers, one type for each container, to enable them to be reached and picked up by appropriate grip members.

Independent grip members running on appropriate rails, usually one for the conductive layers and one for the insulating layers, carry the layers from the storing regions to the assembling station.

This type of apparatus is described in document DE19628163.

The Applicant has found that the apparatus of the above described type can be improved from different points of view, in particular as regards construction simplification, reduction in bulkiness and increase in the production speed, which will bring about a consequent reduction in costs.

In particular, since the various types of conductive and insulating layers are disposed so as to form different stacks, the above mentioned apparatus require wide spaces for their placement.

In addition, due to the great horizontal extension of the storing magazine, also the support structure for the grip members is bulky, complicated and expensive.

Furthermore, the required time to bring each individual layer to the assembling station is long and adversely affects the overall time for the manufacture of each card.

It should be also noted that, in order to move the finished cards from the assembling station to a storing region, a further grip member is required, with a structure associated therewith which is independent of that used to move the individual layers.

Finally, the above described known apparatus do not allow replacement of the typology of card being worked without stopping production over a very long period of time, so as to change all stacks of all conductive and insulating layers and carry out the necessary set-up operations of the different operating members present in the apparatus.

Accordingly, it is an aim of the present invention to provide an apparatus for making cards for multi-layered printed circuits capable of eliminating the above mentioned problems.

In particular, it is an object of the present invention to provide an apparatus of reduced sizes.

It is another object of the present invention to provide an apparatus enabling the cards to be assembled quickly.

It is a further object of the present invention to provide an apparatus enabling cards and layers of different formats to be managed with ease.

Finally, it is an object of the present invention to provide an apparatus of simple construction and reduced costs.

The foregoing and further objects that will become more apparent in the course of the following description, are achieved by an apparatus for making cards for multi-layered printed circuits, comprising the features set forth in claim 1 and in the claims depending thereon.

Further features and advantages will be best understood from the detailed description of a preferred but not exclusive embodiment of an apparatus for making cards for multi-layered printed circuits in accordance with the present invention.

This description will be taken hereinafter with reference to the accompanying drawings, given by way of nonlimiting example, in which:

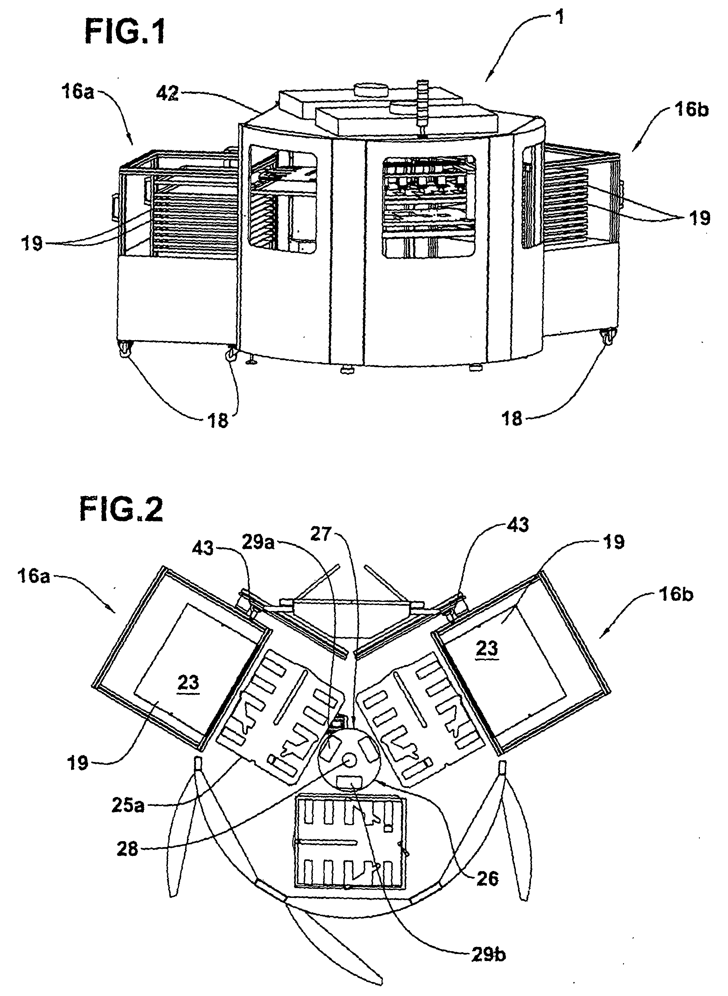

- Fig. 1 is a perspective view of an apparatus for making cards for multi-layered printed circuits embodied by the present invention;
- Fig. 2 is a plan view of the apparatus in Fig. 1 with an upper wall removed;

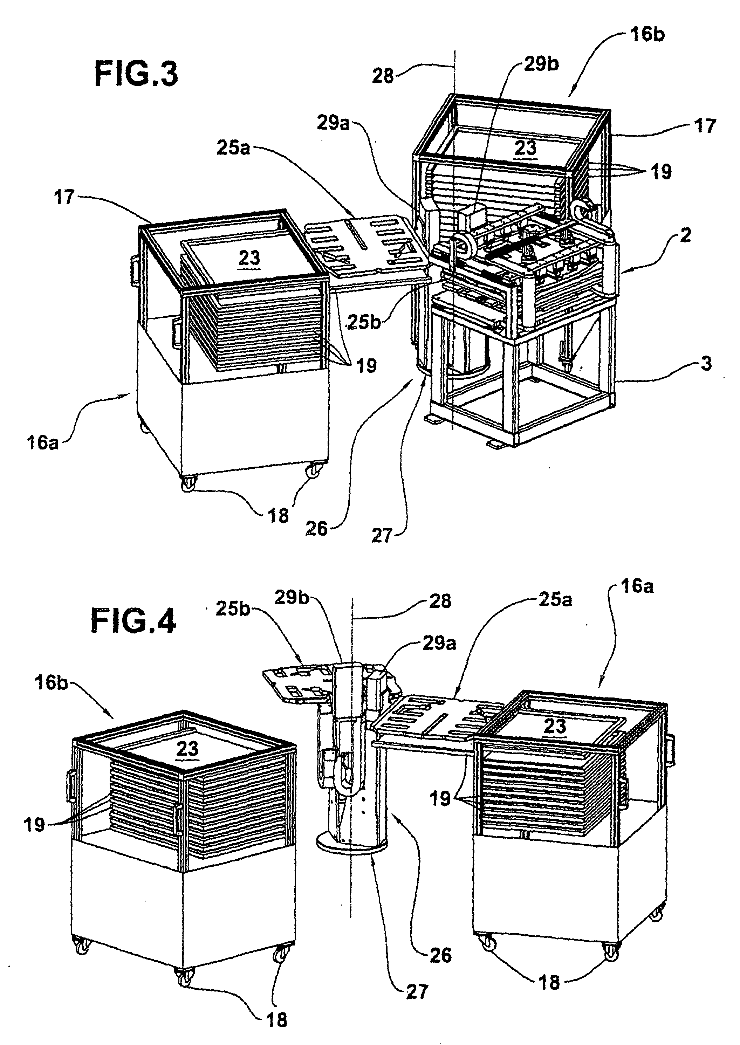

- Fig. 3 is a perspective view of the apparatus in Fig. 1, with the holding cage removed;
- Fig. 4 is a perspective view of the apparatus in Fig. 1, with the holding cage and the assembling station removed;

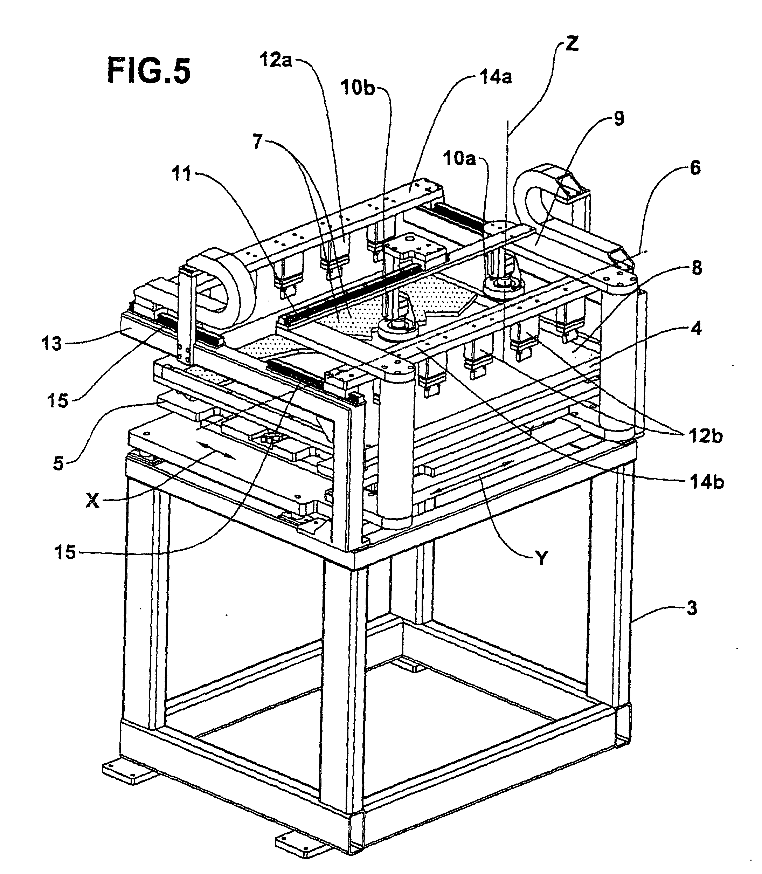

- Fig. 5 is an enlarged perspective view of the assembling station of the apparatus in Fig. 1;

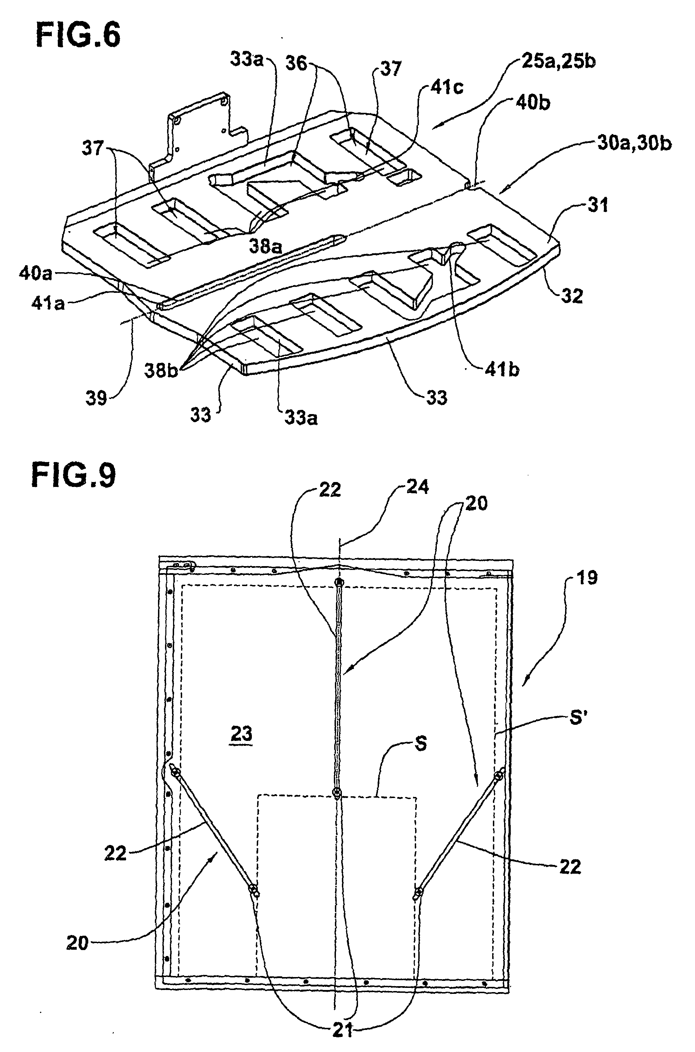

- Fig. 6 is a perspective view of a grip member shown in Fig. 4;

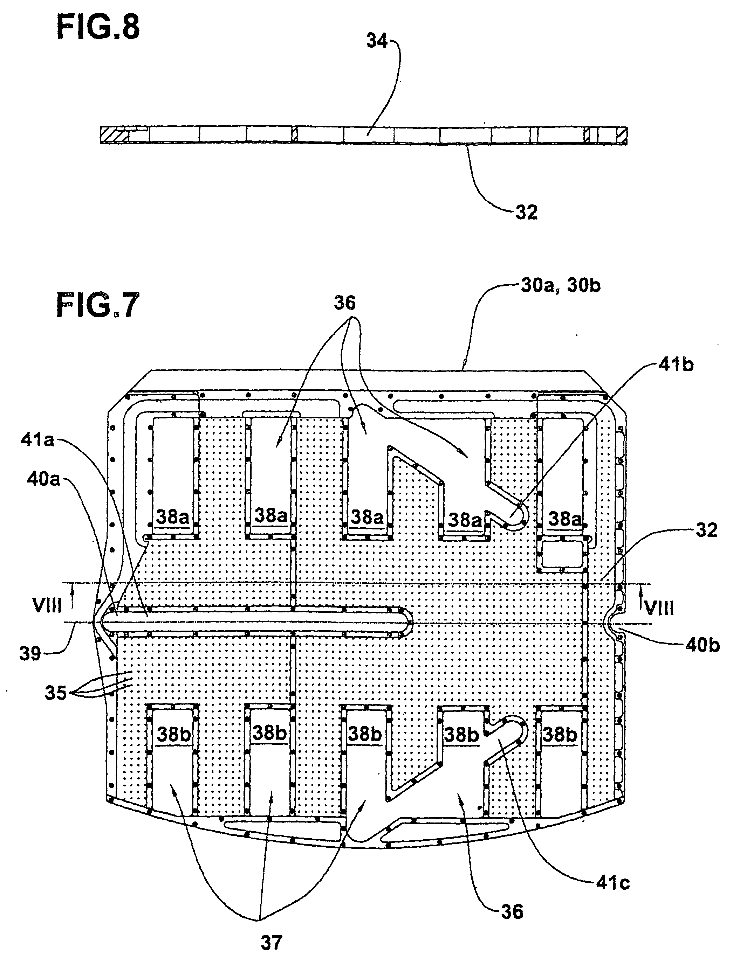

- Fig. 7 is a top view of the grip member shown in Fig. 6, with an upper wall removed;
- Fig. 8 is a section taken along line VIII-VIII in Fig. 7;
- Fig. 9 is a top view of a drawer shown in Fig. 1.

With reference to the drawings, an apparatus for making cards for multi-layered printed circuits in accordance with the present invention has been generally identified by reference numeral 1.

Apparatus 1 comprises an assembling station 2 in which at least two conductive layers and one insulating layer are superposed on each other in an alternated sequence and joined to form a multi-layered card.

The assembling station 2 is preferably made up of a support structure 3 on which an alignment table 4 extending in a horizontal plane is installed. The alignment table 4 has a dual function, i.e. that of supporting the card during assembling and of aligning the already joined conductive layers with each conductive layer added thereto.

The assembling station 2 further comprises appropriate movement means 5 to move the table 4 relative to the support structure 3. In particular, said means 5 enables traversing of table 4 along two directions X, Y that are mutually orthogonal and parallel to the table 4 itself, as well as rotation of same relative to a vertical axis Z.

Preferably table 4 is of a rectangular shape and the two traverse directions X, Y are parallel to the sides of same.

In addition, the vertical rotation axis Z is placed close to one of the minor sides and at a symmetry axis 6 lying in the extension plane of table 4.

In order to keep the first conductive layer of the multi-layered card firmly fixed during laying down of the subsequent layers, table 4 is provided with a plurality of holes 7 communicating with a cavity 8 maintained under vacuum.

The vacuum in cavity 8 generates a sucking effect ensuring adhesion of the first conductive layer to the alignment table 4.

An optical position-detecting device 10 is disposed above table 4, being supported by a first frame 9 integral with the support structure 3.

Such a device comprises two aligned optical detectors 10a, 10b at the symmetry axis 6 of table 4.

In particular, a first optical detector 10a is fastened to the first frame 9 and lies close to the rotation axis Z of table 4, whereas a second optical detector 10b is movable in a direction parallel to table 4 along a track 11 mounted on the first frame 9.

The assembling station 2 further comprises a plurality of welders mounted on a second frame 13. Preferably, welders 12 are divided into two groups 12a, 12b symmetrically arranged at the sides of the optical detectors.

According to the embodiment shown, welders 12 of each group 12a, 12b are aligned along a bar 14a, 14b parallel to the symmetry axis 6 of table 4 and movable, on appropriate rails 15 mounted to the second frame 13, between the edges of table 4 and the symmetry axis 6 of the table itself.

Each individual welder 12 is, in addition, movable in a vertical direction between a first non-operating position, in which it is spaced apart from table 4, and an operating position in which it is close to said table 4 so that it can weld two superposed conductive layers together.

Apparatus 1 in accordance with the invention further comprises a first storing station 16a to store the conductive layers, before use, and a second storing station 16b to store the insulating layers before use and lay down the multi-layered cards, once assembled.

Each storing station 16a, 16b comprises a holding frame 17, mounted on support wheels 18, in which a plurality of mutually superposed drawers 19 are slidably inserted. Each drawer 19 is movable between a first position in which it is inserted in frame 17 and is piled up on the others, and a second position in which it is pulled out of frame 17 to enable either picking up of a conductive or insulating layer or deposit of a finished card.

Each drawer 19 is provided with positioning means 20 enabling conductive layers, insulating layers or finished cards of different sizes to be kept at a predetermined position.

As shown in Fig. 9, said positioning means 20 comprises at least three abutment elements 21 movable in respective slide guides 22 formed in the rest surface 23 of drawer 19.

Preferably, the slide guides 22 are disposed symmetrically of a median axis 24 exhibited by each drawer 19 so that layers of different formats to be assembled can be always blocked at the centre line of the drawer 19 itself.

For the sake of clarity, two layers of different sizes identified by letters S and S' are shown in chain line in Fig. 9.

The storing stations further comprise appropriate means for automatic movement of drawers 19, not shown.

The present apparatus 1 also comprises a first grip member 25a, a second grip member 25b and actuating means 26 for said grip members 25a, 25b, to pick up and transfer the layers and finished cards.

The first grip member 25a is movable in a horizontal direction between the first storing station 16a and the assembling station 2, to pick up a conductive layer and transfer it to the assembling station 2.

The second grip member 25b is movable in a horizontal direction between the assembling station 2 and the second storing station 16b, to bring a finished card from the assembling station 2 to the second storing station 16b and, vice versa, to pick up an insulating layer and take it to the assembling station 2.

Advantageously, the actuating means 26 rigidly connects the first grip member 25a to second grip member 25b in their horizontal movement. Therefore, while the first grip member 25a moves from the first storing station 16a to the assembling station 2, the second grip member 25b moves from the assembling station 2 to the second storing station 16b.

Vice versa, when the first grip member 25a moves from the assembling station 2 to the first storing station 16a, the second grip member 25b moves from the second storing station 16b to the assembling station 2.

According to a preferred embodiment depicted in the accompanying drawings, the actuating means 26 comprises a rotating support structure 27 on which the two grip members 25a, 25b are mounted. Structure 27 rotates around its own vertical axis 28 through an arc of a circle of 120°, therefore the grip members 25a, 25b too are constrained to rotate together following the same arc of a circle.

The grip members 25a, 25b are slidably mounted on structure 27 through respective vertical guides 29a, 29b.

Therefore they can move in a vertical direction between an upper position, close to the uppermost drawer 19, and a lower position, close to the lowermost drawer 19, through a plurality of intermediate positions at heights wherein the remaining drawers 19 are disposed in the storing stations 16a, 16b.

The storing stations 16, 16b and assembling station 2 are circumferentially distributed around the vertical axis 28 of the rotating support structure 27 and mutually spaced apart by an angle of 120°, so that they can be reached by the grip members 25a, 25b through mere angular-rotation movements around the same vertical axis 26.

Advantageously, each of the two grip members 25a, 25b is made up of a horizontal sucking plate 30a, 30b of substantially rectangular shape.

Each plate 30a, 30b comprises an upper wall 31, a lower wall 32, and at least one side wall 33 that altogether bound a chamber 34. In addition, the lower wall 32 has a plurality of holes 35 for communication between chamber 34 and the surrounding atmosphere.

In the same manner as for the alignment table 4, appropriate sucking means, not shown, creates the vacuum in chamber 34 so that the air sucked through holes 35 enables seizure and holding fast of the conductive or insulating layers picked up from the storing stations 16a, 16b and the finished cards hooked in the assembling station 2.

The maximum height that can be reached by plates 30a, 30b is slightly less than the height of the alignment table 4. Each of the plates 30a, 30b when placed close to the assembling station 2, is vertically aligned with the table itself, so that table 4 and plates 30a, 30b are superposed and form a narrow gap between them.

In addition, the two plates 30a, 30b, when placed at the respective storing stations 16a, 16b, are vertically aligned with each drawer 19 jutting out of from the containment frame 17.

Due to the operating mechanism, each drawer 19 is approached from top by the respective plate 30a, 30b so that the sucking lower wall 32 pierced with holes can get into contact with the upper layer in the drawer 19 itself.

To enable the layers to be picked up without any interference with drawer 19 or with the abutment elements 21, the lower wall 32 of each plate 30a, 30b substantially has the same sizes as the rest surface 23 of each drawer 19. In addition, the upper 32 and lower 32 walls of each sucking plate 30a, 30b have a plurality of passages 36 through the plate 30a, 30b itself that are distributed at least along two mutually orthogonal directions to allow access to the tools present in the assembling station 2.

These passages 36 are defined by a plurality of openings 37 bounded by lateral sealing walls 33a disposed between the upper wall 31 and lower wall 32 at the edges of said openings 37.

In particular, to enable welders 32 to place themselves close to table 4, while the plate 30a, 30b is positioned over the table itself, each plate 30a, 30b is provided with a series of first openings 38 through which welders 12 can pass.

In accordance with the embodiment shown, the series of first openings 38 is divided into two groups 38a, 38b of five openings disposed along two mutually opposite sides of the sucking plate 30a, 30b. Preferably, said first openings 38 are of elongated rectangular shape and extend perpendicularly of the major sides of plate 30a, 30b towards a symmetry axis 39 exhibited by the plate 30a, 30b itself.

In addition, to enable pointing of the optical detectors 10a, 10b and reading of the layer position, each plate 30a, 30b is provided with a series of second openings 40 disposed on the symmetry axis 39 of said plates 30a, 30b. When plate 30a, 30b is in the assembling station 2, the second openings 40 are disposed along the action line of the optical detectors 10a, 10b.

Finally, each sucking plate 30a, 30b has a series of third openings 41 in which the abutment elements 21 of drawers 19 can be inserted. As illustrated in the accompanying drawings, the third openings 41 are three in number and are of elongated shape. A first one 41a of the third openings 41 lies on the symmetry axis 39 of plate 30a, 30b; the second 41b and third 41c ones are placed at the sides of the first opening 41a and converge towards said first opening following a symmetrically-converging extension with respect to the symmetry axis 39 of the plate 30a, 30b itself.

As highlighted in the figures, one 40a of the two second openings 40 is coincident with the first one 41a of the third openings 41, whereas the second one 40b of the second openings 40 is defined by a cavity formed in a minor side of plate 30a, 30b.

Preferably, as viewed from the accompanying drawings, the assembling station 2 and grip members 25a, 25b are enclosed in a protection cage 42 to avoid the atmospheric agents damaging the conductive and insulating layers.

The storing stations 16a, 16b face the inside of cage 42 so that drawers 19 when pulled out can be reached by the sucking plates 30a, 30b.

In addition, the apparatus is provided with appropriate means 43 to removably secure each storing station 16a, 16b close to the rotating support structure 27 during operation, for instance through members linking the stations 16a, 16b themselves to cage 42.

Operation of the apparatus described above mainly as regards structure is as follows.

Drawer 19 in which the first conductive layer is placed is opened and the first sucking plate 30a, vertically aligned with the pulled out drawer 19, comes down until it rests on the layer. The sucking means creates the vacuum in chamber 34 so that the air sucked up through holes 35 holds the layer firmly on the lower surface 32 of the first plate 30a.

Subsequently plate 30a rises to the upper position and rotates through 120° until it is in superposed relationship with the alignment table 4 between the table 4 itself and the optical detectors 10a, 10b.

The sucking means of table 4 is started and that of the first plate 30a is shut off so that the layer is laid down on the table and keeps a steady position thereon.

Simultaneously, while the first plate 30a is over plate 4, the second plate 30b, interlocked with the first one 30a in its rotatory motion, picks up an insulating layer from the second storing station 16b.

At this point the two plates rotate through 120° in opposite ways, the first one 30a going back to the first storing station 16b, to pick up a second conductive layer and the second one 30b going back to the region over the alignment table 4 while carrying an insulating layer on its lower wall 32.

Since a precise alignment of the insulating layer is not required, the second plate 30b merely puts the insulating layer down onto the first conductive layer already attached to table 4.

During the subsequent rotation, the first plate 30a brings the second conductive layer, just picked up, over plate 4 on which the first conductive layer and an insulating layer are already disposed.

With the second conductive layer being held on the first plate 30a and through movement of the alignment table 4, the two conductive layers are aligned at their optical references.

At this point welders 12 come down through the first openings 38 of the first plate 30a and press the second conductive layer against the first conductive layer, heating the insulating layer interposed therebetween that partly melts and, in the subsequent solidification step, joins the two conductive layers together.

The aligning and joining cycle is repeated following the above described steps until superposition of the necessary number of layers.

When the last conductive layer has been fastened, the second sucking plate 30b hooks up the whole card, released from table 4 and carries it to the second storing station 16b.

The present invention achieves important advantages.

First of all, the apparatus in accordance with the invention is compact and can be positioned in rooms of small sizes.

In fact, the layers and/or cards, even if of different types, are all contained in two storing stations alone extending in a vertical direction.

In addition, the storing positions of the layers and finished cards, close to the assembling station, enable the spaces occupied by the grip members to be reduced, which will bring about a structural simplification and a reduction in downtime.

Also placement of the table at an upper position with respect to the drawers promotes speeding up of the operations. In fact, the grip member after approaching the drawer from top and carrying out the subsequent picking up, can move towards the upper position without waiting for the drawer being retracted.

Still, the layers are carried to the assembling station during each rotation of the support structure so that no return movements occur, the only function of them being that of bringing the grip members back to the storing stations to hook up a further layer.

In addition, the drawers in accordance with the invention accept layers of different sizes and enable passage to production of cards of different formats without being obliged to stop the machine due to change of the layer type; in fact it is only sufficient to select the pre-set software management parameters.

At all events, even when replacement of the storing stations is required, the operation is very quick since said stations are removably mounted to the apparatus and run on wheels.

Finally, the sucking plates of the apparatus of the invention are such shaped that they can manage layers and cards of different formats without any modifications being required.

In fact, the vacuum generated in the plate chamber is sufficient to firmly hold even layers of small sizes leaving most of the holes of the sucking plate uncovered.

In addition, the openings formed in each plate enable the welders and optical detectors to intervene at the most appropriate positions depending on sizes.

## Claims

1. An apparatus for making multi-layered cards for printed circuits, comprising:
- an assembling station (2) for the conductive and insulating layers;
- a first storing station (16a) for the conductive layers;
- a second storing station (16b) for the insulating layers;
- a first grip member (25a) movable in a horizontal direction between the first storing station (16a) and the assembling station (2) to pick up one conductive layer and transfer it to the assembling station (2);
- a second grip member (25b) movable in a horizontal direction between the second storing station (16b) and the assembling station (2), to pick up one insulating layer and transfer it to the assembling station (2);
- means (26) for actuating the grip members (25a, 25b); **characterized in that** said actuating means (26) rigidly connects the first grip member (25a) with the second grip member (25b) in a horizontal movement.

2. An apparatus as claimed in claim 1, **characterized in that** the actuating means (26) comprises a support structure (29) rotating about a vertical axis (28).

3. An apparatus as claimed in claim 2, **characterized in that** each grip member (25a, 25b) is slidably mounted on the rotating support structure (27) and movable between an upper position and a lower position.

4. An apparatus as claimed in claim 2, **characterized in that** said first and second storing stations (16a, 16b) and assembling station (2) are circumferentially distributed around the vertical axis (28) of the rotating support structure (27).

5. An apparatus as claimed in claim 4, **characterized in that** said first and second storing stations (16a, 16b) and assembling station (2) are mutually spaced apart through an arc of a circle of 120°.

6. An apparatus as claimed in claim 2, **characterized in that** it further comprises means (43) for removably fastening the storing stations (16a, 16b) in their operating positions close to the rotating support structure (27).

7. An apparatus as claimed in claim 1, **characterized in that** each of said grip members (25a, 25b) comprises a horizontal sucking plate (30a, 30b) of substantially rectangular shape.

8. An apparatus as claimed in claim 7, **characterized in that** each sucking plate (30a, 30b) comprises an upper wall (31), a lower wall (32) and at least one side wall (33); the side wall (33) defining, in association with the upper wall (31) and lower wall (32), a chamber (34) at the inside of said plate (30a, 30b) which is adapted to be connected with suction means to create the vacuum in said chamber (34); the lower wall (32) further having a plurality of holes (35) for communication between the chamber (34) and the surrounding atmosphere.

9. An apparatus as claimed in claim 8, **characterized in that** said first storing station (16a) and second storing station (16b) respectively comprise:
- a frame (17);
- a plurality of mutually-superposed drawers (19) each having a rest surface (23) for the conductive layers or the insulating layers, each of said drawers (19) being slidably movable between a first position in which the drawer (19) is inserted in the frame (17) and a second position in which the drawer (19) juts out of the frame (17).

10. An apparatus as claimed in claim 9, **characterized in that** the first and second grip members (25a, 25b) placed at the respective storing stations (16a, 16b) are in vertical alignment with each drawer (19) jutting out of the frame (17) in said second position.

11. An apparatus as claimed in claim 9, **characterized in that** the rest surface (23) of each drawer (19) substantially has the same sizes as the lower wall (32) of each plate (30a, 30b), for the purpose of associating the plate (30a, 30b) with the drawer (19) during picking up of one conductive or insulating layer.

12. An apparatus as claimed in claim 9, **characterized in that** each drawer (19) comprises abutment elements (21) movable in respective slide guides (22), to store layers or multi-layered cards of different sizes.

13. An apparatus as claimed in claim 12, **characterized in that** said slide guides (22) are formed in the rest surface (23) of each drawer (19) and are symmetrically disposed relative to a median axis (24) exhibited by each drawer (19).

14. An apparatus as claimed in claim 7, **characterized in that** the assembling station (2) comprises:
- a support structure (3);
- an alignment table (4) installed on the support structure (3);
- means (5) to traverse and rotate the alignment table (4) along the support structure (3) in a plane parallel to the table (4) itself;
- at least one optical position-detecting device (10) placed over the alignment table (4);
- a plurality of welders (12) set over the alignment table (4), each of said welders (12) being movable between a first position in which it is spaced apart from the table (4) and a second position in which it is close to said table (4).

15. An apparatus as claimed in claim 14, **characterized in that** each grip member (25a, 25b), placed at the assembling station (2), is in superposed relationship with the alignment table (4).

16. An apparatus as claimed in claim 14, **characterized in that** said optical position-detecting device (10) comprises at least two optical detectors (10a, 10b) aligned at a symmetry axis (6) exhibited by the table (4) itself.

17. An apparatus as claimed in claim 16, **characterized in that** at least one of said optical detectors (10a, 10b) is movable parallel to said table (4) and along the symmetry axis (6) of said table (4).

18. An apparatus as claimed in claim 14, **characterized in that** the welders (12) are symmetrically arranged relative to the symmetry axis (6) of the table (4) and movable between the edges of the table (4) and the symmetry axis (6) of said table (4), to fit the layer sizes.

19. An apparatus as claimed in claim 8, **characterized in that** the upper (31) and lower (32) walls of each sucking plate (30a, 30b) have a plurality of passages (36) through said sucking plate (3a0, 30b) distributed at least along two mutually orthogonal directions thereof.

20. An apparatus as claimed in claim 19, **characterized in that** the passages (36) of each sucking plate (30a, 30b) are defined by a plurality of openings (37) formed in the upper (31) and lower (32) walls and bounded by lateral sealing walls (33a); the lateral sealing walls (33a) being disposed between the upper wall (31) and lower wall (32) and at the edges of said openings (37).

21. An apparatus as claimed in claim 14, **characterized in that** each sucking plate (30a, 30b) has a series of first openings (38) for passage of the welders (12); said first openings (38) being placed along two mutually opposite sides of the sucking plate (3a0, 30b) and each having an elongated conformation in a perpendicular direction relative to a symmetry axis (39) of the plate (30a, 30b) itself.

22. An apparatus as claimed in claim 14, **characterized in that** each sucking plate (30a, 30b) has a series of second openings (40) disposed on a symmetry axis (39) of the plate (30a, 30b) itself for pointing of the optical detectors (10a, 10b).

23. An apparatus as claimed in claim 12, **characterized in that** each sucking plate (30a, 30b) has a series of third openings (41) for passage of the abutment elements (21) of the drawers (19); at least two of said third openings (41) having an elongated shape, according to an extension symmetrically converging with respect to a symmetry axis (39) exhibited by the plate (30a, 30b) itself.

## Patentansprüche

1. Vorrichtung zum Herstellen von mehrlagigen Schaltungsplatten, umfassen:
eine Zusammenbaustation (2) von Leiterlagen und Isolierlagen;
eine erste Lagerungsstation (16a) für die Leiterlagen;
eine zweite Lagerungsstation (16b) für die Isolierlagen;
ein erstes Greiforgan (25a), das zwischen der ersten Lagerungsstation (16a) und der Zusammenbaustation (2) horizontal beweglich ist, um eine Leiterlage zu entnehmen und sie der Zusammenbaustation (2) zu übergeben;
ein zweites Greiforgan (25b), das zwischen der zweiten Lagerungsstation (16b) und der Zusammenbaustation (2) horizontal beweglich ist, um eine Isolierlage zu entnehmen und sie der Zusammenbaustation (2) zu übergeben;
Stellmittel (26) der Greiforgane (25a, 25b);
**dadurch gekennzeichnet, dass** die Verstellmittel (26) in der horizontalen Bewegung das erste Greiforgan (25a) mit dem zweiten Greiforgan (25b) starr verbinden.

2. Vorrichtung nach Anspruch 1, **dadurch gekennzeichnet, dass** die Verstellmittel (25)einen um eine senkrechte Achse (28) herum drehbaren Tragaufbau (27) umfassen.

3. Vorrichtung nach Anspruch 2, **dadurch gekennzeichnet, dass** jedes Greiforgan (25a, 25b) am drehbaren Tragaufbau (27) gleitend angebracht und zwischen einer oberen und einer unteren Stellung beweglich ist.

4. Vorrichtung nach Anspruch 2, **dadurch gekennzeichnet, dass** die erste und die zweite Lagerungsstation ((16a, 16b) und die Zusammenbaustation (2) längs des Umfangs um die senkrechte Achse (28) des drehbaren Tragaufbaus (27) verteilt sind.

5. Vorrichtung nach Anspruch 4, **dadurch gekennzeichnet, dass** die erste und die zweite Lagerungsstation (16a, 16b) und die Zusammenbaustation (2) gemäß eines Kreisbogens von 120° voneinander beabstandet sind.

6. Vorrichtung nach Anspruch 2, **dadurch gekennzeichnet, dass** sie überdies Mittel (43) umfasst, um die Lagerungsstationen (16a, 16b) in den Arbeitsstellungen in der Nähe des drehbaren Tragaufbaus (27) entfernbar zu befestigen.

7. Vorrichtung nach Anspruch 1, **dadurch gekennzeichnet, dass** jedes der Greiforgane (25a, 25b) eine horizontale, im wesentlichen rechteckförmige Saugplatte (30a, 30b) umfasst.

8. Vorrichtung nach Anspruch 7, **dadurch gekennzeichnet, dass** jede Saugplatte (30a, 30b) eine obere Wand (31), eine untere Wand (32) und mindestens eine Seitenwand (33) umfasst; wobei die Seitenwand (33)in Zuordnung zur oberen Wand (31) und der unteren Wand (32) eine Kammer (34) innerhalb der Saugplatte (30a, 30b) festlegt, die mit Saugmitteln zur Erzeugung eines Unterdruckes in der Kammer (34) verbindbar ist, wobei die untere Wand (32) überdies eine Vielzahl von Verbindungsbohrungen (35) zwischen der Kammer (34) und der Außenumgebung aufweist.

9. Vorrichtung nach Anspruch 8, **dadurch gekennzeichnet, dass** die erste Lagerungsstation (16a) und die zweite Lagerungsstation (16b) jeweils umfassen:
einen Rahmen (17);
eine Vielzahl von aufeinanderliegenden Fächern (19), die jeweils eine Auflagefläche (23) für die Leitlagen oder für die Isolierlagen aufweist; wobei jedes der Fächer (19) zwischen einer ersten Stellung, in der das Fach (19) im Rahmen (17) aufgenommen ist, und einer zweiten Stellung verstellbar ist, in der das Fach (19) vom Rahmen (17) vorspringt.

10. Vorrichtung nach Anspruch 9, **dadurch gekennzeichnet, dass** das erste und das zweite, im Bereich der jeweiligen Lagerungsstationen (19a, 19b) gestellten Greiforgane (25a, 25b) senkrecht mit jedem Fach (19) ausgerichtet sind, das aus dem Rahmen (17) in der zweiten Stellung vorspringt.

11. Vorrichtung nach Anspruch 9, **dadurch gekennzeichnet, dass** die Auflageebene (23) eines jeden Faches (19) Abmessungen aufweist, die im wesentlichen gleich den Abmessungen der unteren Wand (32) einer jeden Platte (30a, 30b) sind, um die Platte (30a, 30b) dem Fach (19) während der Entnahme einer Leit- oder Isolierlage zuzuordnen.

12. Vorrichtung nach Anspruch 9, **dadurch gekennzeichnet, dass** jedes Fach (19) Anschlagelemente (21) umfasst, die in entsprechenden Führungen (22) zum Einlagern von Lagen oder mehrlagigen Platten verschiedener Abmessungen verstellbar sind.

13. Vorrichtung nach Anspruch 12, **dadurch gekennzeichnet, dass** die Führungen (22) an der Auflagefläche (23) eines jeden Faches ausgenommen und gegenüber einer mittleren, von jedem Fach (19) aufgewiesenen Achse (24) symmetrisch angeordnet sind.

14. Vorrichtung nach Anspruch 7, **dadurch gekennzeichnet, dass** die Zusammenbaustation (2) umfasst:
einen Stützaufbau (3);
einen Ausrichttisch (4), der am Stützaufbau (3) angeordnet ist;
Mittel zum Verschieben und Drehen (5) des Ausrichttisches (4) auf dem Stützaufbau (3) in einer zum Tisch selbst (4) parallelen Ebene;
mindestens einen optischen Positionsfühler (10), der oberhalb des Ausrichttisches (4) angeordnet ist;
eine Vielzahl von Schweißvorrichtungen (12), die oberhalb des Ausrichttisches (4) angeordnet sind, wobei jede der Schweißvorrichtungen (12) zwischen einer ersten Position, in der sie vom Ausrichttisch (4) beabstandet ist, und einer zweiten Position beweglich ist, in der sie am Tisch (4) anliegt.

15. Vorrichtung nach Anspruch 14, **dadurch gekennzeichnet, dass** jedes Greiforgan (25a, 25b), das im Bereich der Zusammenbaustation (2) angeordnet ist, oberhalb des Ausrichttisches (4) liegt.

16. Vorrichtung nach Anspruch 14, **dadurch gekennzeichnet, dass** der optische Positionsfühler (10) mindestens zwei optische Fühler (10a, 10b) umfasst, die im Bereich einer vom Tisch selbst (4) aufgewiesenen Symmetrieachse (6) ausgerichtet sind.

17. Vorrichtung nach Anspruch 16, **dadurch gekennzeichnet, dass** mindestens einer der optischen Fühler (10a, 10b) parallel zum Tisch (4) und längs der Symmetrieachse (6) des Tisches (4) verstellbar ist.

18. Vorrichtung nach Anspruch 14, **dadurch gekennzeichnet, dass** die Schweißvorrichtungen (12) gegenüber der Symmetrieachse (6) des Tisches (4) symmetrisch untergebracht und zwischen den Kanten des Tisches (4) und der Symmetrieachse (6) des Tisches (4) beweglich sind, um sich den Abmessungen der Lagen anzupassen.

19. Vorrichtung nach Anspruch 8, **dadurch gekennzeichnet, dass** die obere (31) und untere (32) Wand einer jeden Saugplatte (30a, 30b) eine Vielzahl von Durchbrüchen (36) durch die Saugplatte (30a, 30b) aufweist, die mindestens längs zwei zueinander senkrechten Richtungen verteilt sind.

20. Vorrichtung nach Anspruch 19, **dadurch gekennzeichnet, dass** die Durchbrüche (36) einer jeden Saugplatte (30a, 30b) durch eine Vielzahl von Öffnungen (37) festgelegt sind, die in der oberen (31) und unteren (32) Wand ausgenommen sind und durch seitliche Dichtwände (33a) begrenzt sind, wobei die seitlichen Dichtwände (33a) zwischen der oberen (31) und der unteren (32) Wand und im Bereich der Kanten der Öffnungen (37) angeordnet sind.

21. Vorrichtung nach Anspruch 14, **dadurch gekennzeichnet, dass** jede Saugwand (30a, 30b) eine Reihe von ersten Öffnungen (38) für den Durchgang der Schweißvorrichtung (12) aufweist; wobei die Öffnungen (38) längs zwei zueinander abgewandten Seiten der Saugplatte (30a, 30b) angeordnet sind und jede eine längliche Ausbildung senkrecht zur von der Saugplatte selbst (30a, 30b) aufgewiesene Symmetrieachse (39) aufweist.

22. Vorrichtung nach Anspruch14, **dadurch gekennzeichnet, dass** jede Saugplatte (30a, 30b) eine Reihe von zweiten Öffnungen (40) aufweist, die an einer von der Saugplatte selbst (30a, 30b) aufgewiesene Symmetrieachse (39) angeordnet sind, um die optischen Fühler (10a, 10b) zu steuern.

23. Vorrichtung nach Anspruch 12, **dadurch gekennzeichnet, dass** jede Saugplatte (30a, 30b) eine Reihe von dritten Öffnungen (41) für den Durchgang der Anschlagelemente (21) der Fächer (19) aufweist; wobei mindestens zwei der drei Öffnungen (41) eine längliche Form gemäß einer Abwicklung aufweisen, die gegenüber einer von der Saugplatte selbst (30a, 30b) aufgewiesenen Symmetrieachse (39) symmetrisch zusammenläuft.

## Revendications

1. Appareil pour la fabrication de cartes à multicouches de circuits imprimés, comprenant:
- un poste d'assemblage (2) pour les couches conductrices et les couches isolantes;
- un premier poste de stockage (16a) pour les couches conductrices;
- un deuxième poste de stockage (16b) pour les couches isolantes;
- un premier organe de prise (25a) mobile en direction horizontale entre le premier poste de stockage (16a) et le poste d'assemblage (2) pour saisir une couche conductrice et la transférer au poste d'assemblage (2);
- un deuxième organe de prise (25b) mobile en direction horizontale entre le deuxième poste de stockage (16b) et le poste d'assemblage (2), pour saisir une couche isolante et la transférer au poste d'assemblage (2);
- des moyens (26) destinés à entraîner les organes de prise (25a, 25b);
**caractérisé en ce que** lesdits moyens d'entraînement (26) relient rigidement le premier organe de prise (25a) au deuxième organe de prise (25b) dans le mouvement horizontal.

2. Appareil selon la revendication 1, **caractérisé en ce que** les moyens d'entraînement (26) comportent une structure de support (29) tournant autour d'un axe vertical (28).

3. Appareil selon la revendication 2, **caractérisé en ce que** chaque organe de prise (25a, 25b) est monté à coulissement sur la structure de support tournante (27) et est mobile entre une position supérieure et une position inférieure.

4. Appareil selon la revendication 2, **caractérisée en ce que** lesdits premier et deuxième postes de stockage (16a, 16b) et le poste d'assemblage (2) sont distribués d'une façon circonférencielle autour de l'axe vertical (28) de la structure de support tournante (27).

5. Appareil selon la revendication 4, **caractérisé en ce que** lesdits premier et deuxième postes de stockage (16a, 16b) et le poste d'assemblage (2) sont espacés réciproquement selon un arc de cercle de 120°.

6. Appareil selon la revendication 2, **caractérisé en ce qu'**il comporte en outre des moyens (43) pour fixer de manière amovible les postes de stockage (16a, 16b) à leurs positions de travail, à proximité de la structure de support tournante (27).

7. Appareil selon la revendication 1, **caractérisé en ce que** chaque organe de prise (25a, 25b) comporte une plaque d'aspiration horizontale (30a, 30b) de forme essentiellement rectangulaire.

8. Appareil selon la revendication 7, **caractérisé en ce que** chaque plaque d'aspiration (30a, 30b) comporte une paroi supérieure (31), une paroi inférieure (32) et au moins une paroi latérale (33); la paroi latérale (33) définissant, en combinaison avec la paroi supérieure (31) et la paroi inférieure (32), une chambre (34) à l'intérieur de ladite plaque (30a, 30b) laquelle est apte à être reliée à des moyens d'aspiration pour créer le vide dans ladite chambre (34); la paroi inférieure (32) ayant en outre une pluralité de trous (35) pour la communication entre la chambre (34) et l'atmosphère environnante.

9. Appareil selon la revendication 8, **caractérisé en ce que** lesdits premier poste de stockage (16a) et deuxième poste de stockage (16b) comportent respectivement:
- un bâti (17);
- une pluralité de tiroirs (19) placés au-dessus les uns des autres et ayant chacun une surface d'appui (23) pour les couches conductrices ou les couches isolantes, chacun desdits tiroirs (19) étant mobile par coulissement entre une première position à laquelle le tiroir (19) est inséré dans le bâti (17) et une deuxième position à laquelle le tiroir (19) fait saillie du bâti (17).

10. Appareil selon la revendication 9, **caractérisé en ce que** les premier et deuxième organes de prise (25a, 25b) placés aux postes de stockage respectifs (16a, 16b) sont en alignement vertical avec chaque tiroir (19) faisant saillie du bâti (17) à ladite deuxième position.

11. Appareil selon la revendication 9, **caractérisé en ce que** la surface d'appui (23) de chaque tiroir (19) a essentiellement les mêmes dimensions que la paroi inférieure (32) de chaque plaque (30a, 30b), dans le but d'associer la plaque (30a, 30b) au tiroir (19) pendant l'enlèvement d'une couche conductrice ou isolante.

12. Appareil selon la revendication 9, **caractérisé en ce que** chaque tiroir (19) comporte des éléments de butée (21) mobiles dans des glissières respectives (22) pour l'emmagasinage des couches ou des cartes à multicouches de dimensions différentes.

13. Appareil selon la revendication 12, **caractérisé en ce que** lesdites glissières (22) sont formées dans la surface d'appui (23) de chaque tiroir (19) et sont disposées symétriquement par rapport à un axe médian (24) présenté par chaque tiroir (19).

14. Appareil selon la revendication 7, **caractérisé en ce que** le poste d'assemblage (2) comporte:
- une structure de support (3);
- une table d'alignement (4) installée sur la structure de support (3);
- des moyens (5) pour effectuer la translation et la rotation de la table d'alignement (4) le long de la structure de support (3) dans un plan parallèle à la table (4) elle-même;
- au moins un dispositif optique de détection de la position (10) mis au-dessus de la table d'alignement (4);
- une pluralité de dispositifs de soudage (12) installés sur la table d'alignement (4), chacun desdits dispositifs de soudage (12) étant mobile entre une première position à laquelle il est espacé de la table (4) et une deuxième position à laquelle il est proche de ladite table (4).

15. Appareil selon la revendication 14, **caractérisé en ce que** chaque organe de prise (25a, 25b) mis au poste d'assemblage (2) est en relation de superposition avec la table d'alignement (4).

16. Appareil selon la revendication 14, **caractérisé en ce que** ledit dispositif optique de détection de la position (10) comporte au moins deux détecteurs optiques (10a, 10b) alignés en correspondance avec un axe de symétrie (6) présenté par la table (4) elle-même.

17. Appareil selon la revendication 16, **caractérisé en ce qu'**au moins un desdits détecteurs optiques (10a, 10b) est mobile parallèlement à ladite table (4) et le long de l'axe de symétrie (6) de la table (4).

18. Appareil selon la revendication 14, **caractérisé en ce que** les dispositifs de soudage (12) sont disposés symétriquement par rapport à l'axe de symétrie (6) de la table (4) et mobiles entre les bords de la table (4) et l'axe de symétrie (6) de ladite table (4), pour s'adapter aux dimensions des couches.

19. Appareil selon la revendication 8, **caractérisé en ce que** les parois supérieure (31) et inférieure (32) de chaque plaque d'aspiration (30a, 30b) ont une pluralité de passages (36) à travers ladite plaque d'aspiration (30a, 30b) distribués au moins le long de deux directions réciproquement perpendiculaires.

20. Appareil selon la revendication 19, **caractérisé en ce que** les passages (36) de chaque plaque d'aspiration (30a, 30b) sont définis par une pluralité d'ouvertures (37) formées dans les parois supérieure (31) et inférieure (32) et délimitées par des parois latérales étanches (33a); les parois latérales étanches (33a) étant disposées entre la paroi supérieure (31) et la paroi inférieure (32) et aux bords de ladite ouverture (37).

21. Appareil selon la revendication 14, **caractérisé en ce que** chaque plaque d'aspiration (30a, 30b) a une série de premières ouvertures (38) pour le passage des dispositifs de soudage (12); lesdites premières ouvertures (38) étant placées le long de deux côtés réciproquement opposés de la plaque d'aspiration (30a, 30b) et chacune ayant une conformation allongée dans une direction perpendiculaire par rapport à un axe de symétrie (39) de la plaque (30a, 30b) elle-même.

22. Appareil selon la revendication 14, **caractérisé en ce que** chaque plaque d'aspiration (30a, 30b) a une série de deuxièmes ouvertures (40) disposées sur un axe de symétrie (39) de la plaque (30a, 30b) elle-même pour le pointage des détecteurs optiques (10a, 10b).

23. Appareil selon la revendication 12, **caractérisé en ce que** chaque plaque d'aspiration (30a, 30b) a une série de troisièmes ouvertures (41) pour le passage des éléments de butées (21) des tiroirs (19); au moins deux desdites troisièmes ouvertures (41) ayant une forme allongée suivant une extension convergeant symétriquement par rapport à un axe de symétrie (39) présenté par la plaque (30a, 30b) elle-même.
